# EUROPEAN PATENT SPECIFICATION

(11) **EP 3 710 840 B1**
(45) Date of publication and mention of the grant of the patent: **07.06.2023**
(21) Application number: 18807026.2
(22) Date of filing: 14.11.2018
(51) Int. Cl.: G01R 15/20, G01R 19/25, H02P 6/08, G01R 33/00

(54) **CURRENT CONTROLLING TRANSDUCER**
STROMREGULIERENDER WANDLER
TRANSDUCTEUR DE COMMANDE DE COURANT

(30) Priority: 15.11.2017 EP 17201932
(43) Date of publication of application: 23.09.2020
(73) Proprietor: LEM International SA, 1228 Plan-les-Ouates (CH)
(72) Inventor: MAEDER, Pascal, 1412 Ursins (CH); SCHLÄFLI, Dominik, 1260 Nyon (CH); TROMBERT, Stephan, 74320 Leschaux (FR); BOSSONEY, Luc, 1423 Villars-Burquin (CH)
(74) Representative: reuteler & cie SA
(86) International application number: PCT/EP2018/081266
(87) International publication number: WO 2019/096865

(56) References cited:
- EP-A1- 1 956 378
- EP-A1- 3 133 291
- US-A- 4 980 794
- US-A1- 2013 138 372
- US-A1- 2015 070 006
- US-A1- 2016 181 966
- US-A1- 2016 309 592
- US-A1- 2017 317 598
- US-B2- 7 459 900
- US-B2- 9 746 499

## Description

The present invention relates to a current transducer for control of a power conversion system such as an electrical motor drive.

Electrical motor drives and other systems that convert electrical energy into mechanical power often have current transducers that measure the current supplied to the electrical phases of the motor and that are typically connected to a control loop that controls the operation of the motor. Electrical current transducers are typically supplied as separate components that output a current signal to be processed in a control unit or in a power supply unit connected to the electrical motor. The assembly of various separate components that are essential to the control of the electrical motor however reduces the reliability of the motor, or more generally of any power conversion systems subject to harsh operating conditions that such as vibration, mechanical shocks, and thermal variations, for instance as found in automobiles, trains and other vehicles. Besides the reliability issues, assembly and compatibility issues may cause problems and possible interferences in the coupling between transducers and control units, which may also affect reliability and performance. Examples of known implementations can be found in the documents US 9 746 499 B2 and US 4 980 794 A. In particular, US 9 746 499 B2 discloses a hybrid current sensor assembly including a conductor to be connected to both terminals of an external electronic device, a Hall core to which a magnetic field generated by a current flowing in the conductor is applied, a Hall sensor in which a potential difference occurs at both ends thereof due to the magnetic field applied to the Hall core, a shunt terminal configured to shunt the current flowing in the conductor, and a microprocessor connected to the shunt terminal and configured to measure the current flowing in the conductor. On the other hand, US 4 980 794 A discloses a motor controller or contactor which utilizes a non-saturating current transformer for sensing the amount of current flowing in the electrical conductor connected to the contactor.

In view of the forgoing it is an objective to this invention to provide a current transducer for the control of an electrical power conversion system, such as an electrical motor, that is reliable and cost effective.

It is advantageous to provide a current transducer for control of a power conversion system that is compact and easy to store.

It is advantageous to provide a current transducer for control of power conversion system that is easy to store, configure and control.

Objects of this invention have been achieved by providing a current controlling transducer according to claim 1. Additional embodiments are defined in the dependent claims. The description and drawings also present further aspects, examples, and non claimed embodiments for the better understanding of the claimed embodiments.

Further objects and advantageous features of the invention will be apparent from the following detailed description in relation to the annexed drawings in which:

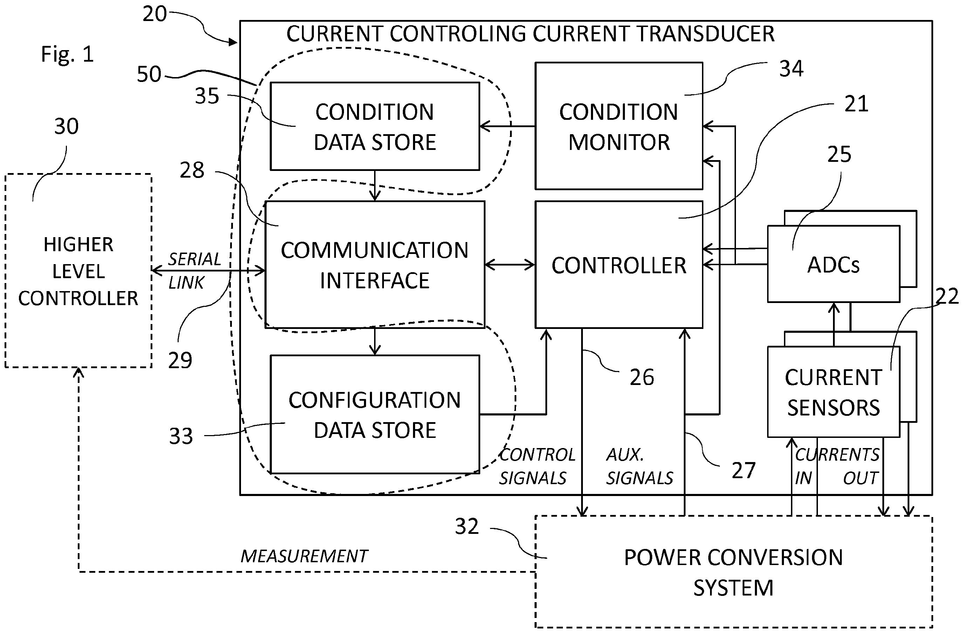

Figure 1 is a schematic block diagram illustrating a current controlling transducer according to an embodiment of the invention;
Figure 2 is a schematic view in perspective of a current controlling transducer according to an embodiment of the invention with a housing removed (and certain details of this circuit board and components not illustrated for simplicity);
Figures 3a and 3b are schematic views in perspective of a first side, respectively a second side of a current controlling transducer according to another embodiment of the invention with a housing removed (and certain details of this circuit board and components not illustrated for simplicity);
Figure 4 is a schematic view in perspective of a current controlling transducer according to another embodiment of the invention with a housing removed (and certain details of this circuit board and components not illustrated for simplicity);

Referring to the figures, a current controlling transducer 20 according to embodiments of the invention comprises a circuit board 1, one or more current sensors 22 mounted on the circuit board, a microprocessor 8 mounted on the circuit board, and a connector 3 connected to the circuit board 1 and providing connection terminals for connection to an external circuit. The external circuit may in particular comprise a circuit board of a higher level controller 30 connected to a power conversion system 32, or connected to and mounted in a power conversion system 32.

The microprocessor 8 may comprise one or more integrated circuits that include a memory 50, a controller 21, an analog-to-digital converters (ADCs) 25, and a communication interface module 28.

The memory 50 comprises a non-volatile memory such as a read-only memory (ROM), an erasable programmable ROM (EPROM), an electrically erasable programmable read-only memory (EEPROM), a flash memory, a ferroelectric RAM, a solid-state drive (SSD) and other know forms of non-volatile memory. The memory 50 may further comprise a volatile memory such as a random-access memory (RAM) or a dynamic RAM (DRAM) or a static RAM (SRAM).

The microprocessor further comprises a configuration data store 33.

The microprocessor 8 may, in an embodiment, further comprise a condition module comprising a condition monitor 34 and a condition data store 35.

The configuration data store 33 and condition data store 35 may be comprised in portions of the memory 50, in particular the non-volatile memory of the memory 50.

The communication interface 28 is configured to exchange data with the higher level controller 30 through one or more terminals of the connector 3, for instance by a serial link 29. Connection terminals of the connector may further interconnect the microprocessor 8, in particular the controller 21 thereof, to the power conversion system 32 via output 26 and input 27 connections that form part of a control loop for control of the power conversion system 32 by the controller 21 as a function of the current or currents measured by the current sensors 22.

The current sensors 22 measure the electrical current driving the one or more electrical phases of the power conversion system 32. Each current sensor 22 comprises a primary conductor 6 and a magnetic field sensor 7 configured to detect the magnetic field generated by the current flowing in each primary conductor 6.

Each primary conductor 6 is provided with an input terminal 6a and output terminal 6b that form part of the connector 3 for connection to the aforesaid external circuit of the power conversion system 32. Each current sensor 22 measures the current flowing in a corresponding electrical phase supplied to the power conversion system 32 and is connected to the analog to digital convertor (ADC) 25 which in turn is connected to the controller 21. The analog signals outputted by the current sensors represent an image of the primary current flowing in the primary conductors 6, which after conversion by the ADCs 25, can be processed by the controller 21.

A set point current value corresponding to the desired power conversion system control state, may be provided by the higher level controller 30 via the communications link 29 (for instance a serial link), or by the power conversion system 32 via the input 27, or else correspond to control values stored in the memory 50 or be computed in the controller 21 of the current controlling transducer 20. Based on the current measurement from the current sensors 22 and the set point current value, the power conversion system 32 may thus be controlled in a feedback loop by the current controlling transducer 20.

The current measurement signals from current sensors 22 may also be digitally stored in the memory 50, in particular in the condition data store 35 portion thereof, after processing of the signals via the condition monitor 34 that may for instance record only certain values that exceed stored threshold values, or at specified time intervals. The set point current value control information can also be provided by the controller 21, for example based on a speed error signal provided by the higher level controller 30 and motor drive parameters stored in the configuration data store 33.

Auxiliary signals such as input voltage, temperature or other parameters fed to the current controlling transducer 20 from the power conversion system 32 through the input 27, may also be used by the controller 21 to adapt its output signal for control of the power conversion system 32 as a function of the aforesaid input parameters. The signals processed by the controller 21 generate a sequence of combinations of control signals to drive for instance the switching elements in the power conversion system 32 to achieve the desired current values.

The characteristics of the power conversion system and information on how to perform adequate control may be stored in the configuration data store 33. This information or a portion thereof may also be provided to the configuration data store by the higher level controller 30 via the communication interface 28 for instance during an initialization phase of the power conversion system, or at defined sampling instants of the control scheme during operation of the power conversion system.

An additional function of the current controlling transducer is condition monitoring. The condition monitor 34 may obtain the same current and auxiliary signals as the controller 21 that may be configured to evaluate them with the purpose of identifying variations in the signals indicating wear or incipient malfunction with a goal of alerting the need for maintenance or to generate an alarm of impending malfunction. The detailed analysis of the current sensor and auxiliary signals over time yields information about the system which allows for instance motor current signature analysis in a motor drives to identify vibration, eccentricity, rotor bar breakage, bearing wear and other issues. In the case of the power conversion system being a motor drive, MCSA (motor current signal analysis) requires similar transforms into stator and rotor frames of reference as the current control loop, an example being the detection of broken rotor bars which can be effected advantageously in the rotor frame of reference. The diagnostic information obtained by the condition monitor 34 may also include logging events that are stored in the condition data store 35. Information in the data store can be read periodically by the higher level controller 30 and relayed to productive maintenance systems for scheduling interventions and maintenance.

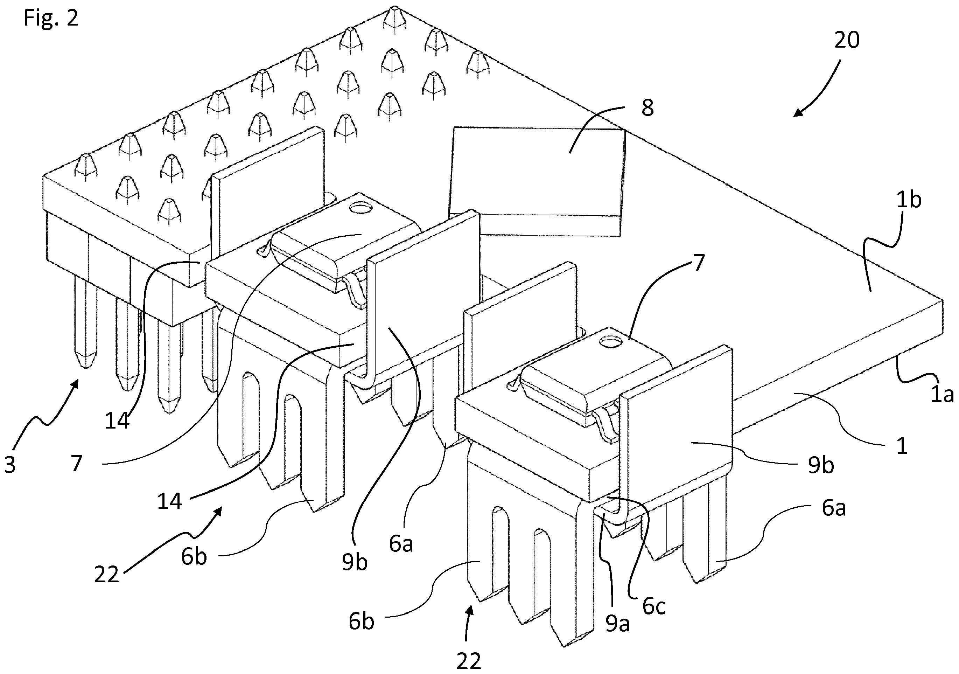

Referring now to figures 2 to 4, embodiments of a current controlling transducer (not showing the housing and certain details of the circuit board) are illustrated. The embodiment of figure 2 comprises two current sensors 22, each for connection to a different electrical phase of a power conversion system. The power conversion system may for instance be a three phase motor or a two phase motor, whereby with respective three phase motor it is possible to control the motor by measuring the current and voltage in only two of the three phases. Within the scope of the invention it is however possible to have more than two current sensors on the circuit board 1 or have only a single current sensor depending on the application, in particular depending on how the power conversion system is to be controlled.

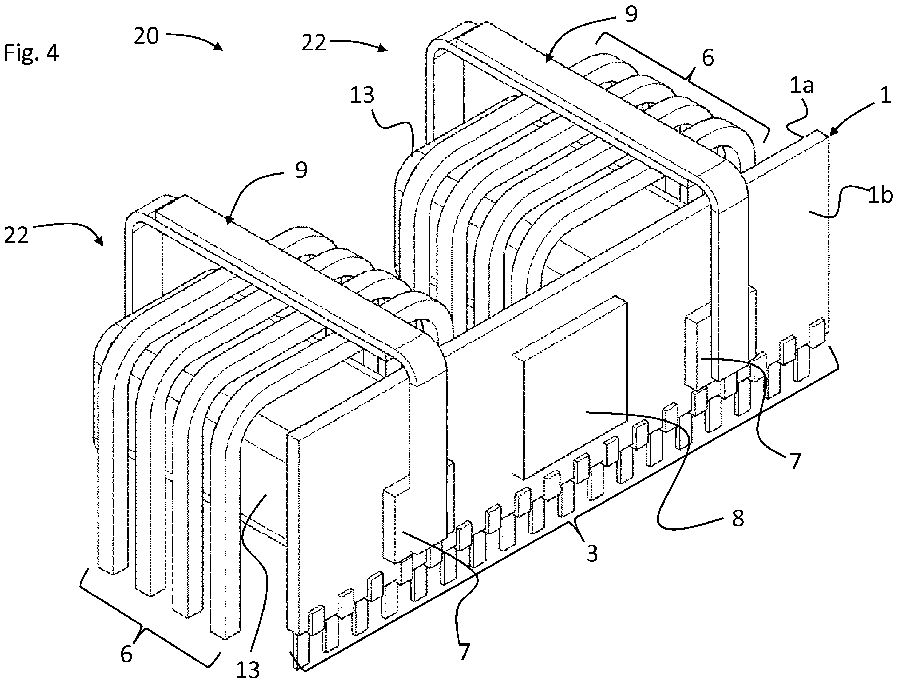

Each of the current sensors 22 comprises a primary conductor 6 that is substantially in a form of a U-shaped electrical terminal that is mounted against first side 1a of the circuit board, the possibly U-shaped primary conductors 6 comprising connection terminals 6a, 6b for connection to a primary conductor of the power conversion system 32. The terminals 6a, 6b are shown in the illustrated environment as pin terminals (fig. 2 and 4), however any terminal connection ends may be provided within the scope of the invention, for instance surface mount connection ends or receptacle contacts or other known forms of contacts, including contacts for pluggable connection to a complementary connector.

The primary conductor 6 may be fixed to the circuit board 1 by a solder connection or by welding to metallized circuit traces formed on the first side 1a of the circuit board. Other bonding or mechanical fixing techniques may be employed.

Each electrical current sensor 22 advantageously further comprises a magnetic core 9 made of a high permeability magnetic material configured to conduct the magnetic flux generated by the primary current to be measured flowing in the primary conductors 6. Each magnetic core 9 in this embodiment has a general U-shape and is configured with a middle section 9a of the U-shape positioned below the primary conductor, and the lateral branches 9b extending from the middle section 9a through slots 14 in the circuit board 1 such that the primary conductor is partially surrounded by the magnetic core 9. This circuit board 1 is thus advantageously provided with slots 14 therein to allow the lateral branches 9b of the magnetic core to be inserted therethrough and surround at least partially a section 6c of the primary conductor 6 and the magnetic field detector 7.

The magnetic core reduces the influence of external magnetic fields on the current measurement and also concentrates the magnetic flux for the magnetic field detectors 7 mounted on the second side 1b of the circuit board, opposite the first side 1a.

In the illustrated embodiment, magnetic field sensors may advantageously comprise Hall effect sensors, for instance in the form of an application's specific integrated circuit (ASIC) mounted on the second side 1b of the circuit board and connected to circuit traces thereon for interconnection to the microprocessor 8 and to connection terminals of the connector 3. An insulating layer is provided between the magnetic core 9 and the primary conductor 6 in order to ensure electrical separation therebetween. Optionally, an insulating layer may be provided, for instance by overmolding or by a potting compound encapsulated by an outer casing, over one or both sides of the circuit board 1 to cover all or portions of the magnetic core 9, the magnetic field sensors 7, and circuit traces on the circuit board. The magnetic cores 9 may comprise a connection (not shown) to an electrical circuit trace on a circuit board 1 for a ground connection of the magnetic core.

Within the scope of the invention, the magnetic core may have shapes other than a general U-shape, for instance the lateral branches 9b may be folded over around the magnetic field sensors 7 to partially or completely surround the magnetic field sensor.

Advantageously, the direct integration of the primary conductor, the magnetic field sensor and the magnetic core on and within the circuit board 1 for direct connection to the microprocessor 8 and connection terminals of the connector 3 provides a very compact arrangement with reliable short interconnection paths between components, leading to a reduced risk of interference from external electrical and magnetic fields as well as higher performance and greater reliability.

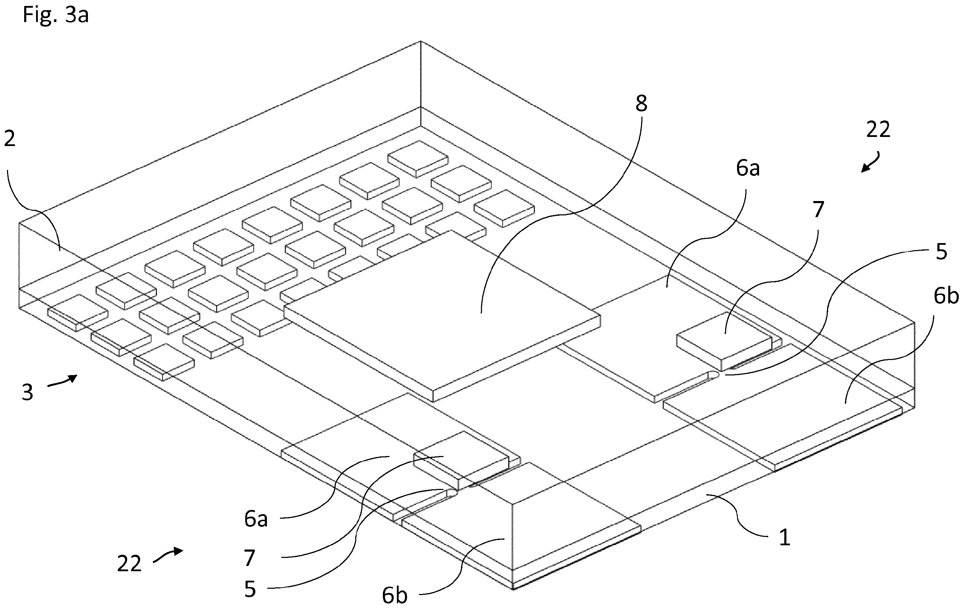

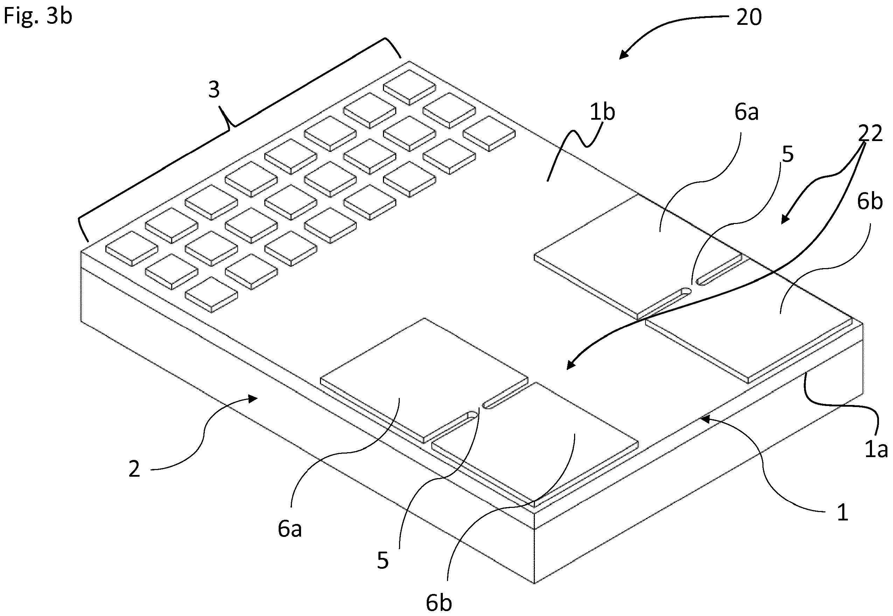

Referring to figures 3a, 3b, another embodiment of a current controlling transducer according to the invention is schematically illustrated. In this embodiment, the primary conductor 6 is comprised of circuit traces provided on a first side of 1a of the circuit board 1, and the magnetic field sensors 7 and microprocessor 8 are mounted on the second side 1b of the circuit board. Connection terminals of the connector 3 may have various configurations as already described in relation to embodiment illustrated in figure 2. In the illustrated variant of figures 3a, 3b the connection layout is implemented in a Land Grid Array (LGA) package that comprises the circuit board 1 and an overmold layer 2 on the second side 1b of the circuit board covering the magnetic field sensors and microprocessor 8. The circuit traces on the first side 1a include the interface connection terminals 3 which may include ground, power supply, the serial interface interconnection, the control signal interconnections, auxiliary signal input and output connections and other connection terminals that may be needed for the circuit.

The primary conductors 6 in the embodiment of figures 3a, 3b, comprise input circuit trace pads 6a and output circuit trace pads 6b interconnected by a narrow bridge section 5 adjacent to which the magnetic field detector 7 is mounted. The short and narrow bridge section 5 results in a strong increase in primary current density leading to a stronger magnetic field that is sensed by the magnetic field sensor 7. Because the bridge section 5 is very short, the electrical resistance of the bridge remains acceptable and because it is thermally well connected to the large metallic pads 6a, 6b, the temperature rise of the primary conductors is reduced under practical operating conditions. The magnetic field sensors 7 output a signal proportional to the measured current. As described in relation to the embodiment of figure 2, the output of the magnetic field detectors 7 is connected to the microprocessor 8, in particular the ADCs 25 thereof for digital processing of the current measurement signal. The measured current information may then be processed by an algorithm in the controller 21 in combination with set point current values obtained through the communication interface 29 from the higher level controller 30 to generate control signals that operate the power conversion system 32 in order to obtain a current output close to the set point current value.

Referring now to figure 4, another embodiment of a current controlling transducer according to an embodiment of the invention is illustrated. In this embodiment, the connection terminals of the connector 3 extend along an edge 1c of the circuit board. A magnetic core 9 of each current sensor surrounds a primary conductor 6 and extends through a coil former of a compensation coil 13. An airgap is formed between the branch that extends through the coil former of the compensation coil up to a first side 1a of the circuit board and an end branch 9a extending over the second side 1b of the circuit board. The magnetic field detector 7 mounted on the second side of the circuit board is positioned in the airgap. The primary conductor 6 comprises a plurality of conductor sections 6' which in the illustrated embodiment form U-shaped conductors sections that are mounted around the compensation coil 13. The magnetic field sensors 7 in the airgap sense the magnetic flux density produced by the current linkage of the primary conductor 6 and the compensation coil 13; their output is connected to a negative feedback circuit that amplifies this sensed magnetic signal to drive the compensation current to the point where the flux density in the air gap is close to zero. At this point, the primary and secondary current linkages are of essentially equal and opposite value. Such compensation coils coupled to primary conductors function in a closed-loop manner that is *per se* well known in the art and need not be described in more detail. It may however be noted that at high frequencies the magnetically coupled primary conductor 6 and compensation coil 13 may operate as a current transformer with the induced voltage driving the compensation circuit, with the same current-to-voltage conversion through a measurement resistor operating in both low frequency and high frequency modes.

In the embodiment of figure 4, the plurality of primary conductor sections 6' may be interconnected to form one or more windings around the compensation coil 13 in order to adjust the current sensor to a specified range of primary currents to be measured. The interconnections to form the windings may be provided on the circuit trace layout of an external circuit board or connection unit to which the current controlling transducer is mounted or connected. The primary conductor section, compensation coil and magnetic core may be overmolded by a dielectric material or otherwise housed in a dielectric material.

### List of references

Current controlling transducer 20
   Circuit board 1
      First side 1a
      Second side 1b
      Overmold 2
      Connector 3
      Primary conductor slots 14
   Microprocessor 8
   Controller 21
      Output 26
      input 27
   Current sensor 22
      Narrow bridge section 5
      Primary conductor 6
         input terminal 6a
         Output terminal 6b
         Middle section 6c
      Magnetic field sensor 7
      Magnetic core 9
         Middle section 9a
         End branch 9b
         Compensation coil 13
   Analog-to-Digital Converter (ADC) 25
   Communication interface 28
   Condition monitor 34
   Memory 50
      Condition data store 35
      Configuration data store 33
   Higher level controller 30
      Communication link 29 (e.g. serial link)
Power Conversion System 32

## Claims

1. A current controlling transducer comprising a circuit board (1), one or more current sensors (22), at least one microprocessor (8) on the circuit board, and a connector (3) with connection terminals connected to the circuit board and configured to be connected, via an external connector or an additional circuit board, to a power conversion system (32) and a higher level controller (30) external to the transducer,
wherein each current sensor comprises a primary conductor (6) with input and output terminals (6a, 6b) configured to be connected to an electrical phase of the power conversion system, and a magnetic field detector (7) configured to measure the magnetic field generated by a primary current flowing in the primary conductor, each current sensor being connected to a controller (21) of the microprocessor,
the microprocessor further comprising
a communication interface (28) configured to communicate with the higher level controller via the connections terminals of the connector, and
a memory (50) comprising a configuration data store (33) configured to store information concerning a configuration of the power conversion system,
wherein the microprocessor is connected to one or more control signal connection terminals of the connector configured to be connected to the power conversion system for control thereof based on set point current values and the one or more primary currents measured by the current sensors,
wherein the set point current values are provided by the higher level controller (30), the power conversion system (32), or the memory (50) or are computed and provided by the controller (21) based on the information concerning the configuration of the power conversion system stored in the configuration data store (33), and
wherein the primary conductor, the magnetic field sensor, the microprocessor, the circuit board and the connector are directly integrated together to form a single unit connectable to the power conversion system and a controller of the power conversion system.

2. The current controlling transducer according to the preceding claim wherein the microprocessor (8) further comprises an analog to digital circuit (25), and wherein each current sensor is connected to the analog to digital circuit (25) of the microprocessor.

3. The current controlling transducer according to any preceding claim wherein the connection terminals of the connector are provided on a first side (1a) of the circuit board and the magnetic field sensor and microprocessor are mounted on a second side (1b) of the circuit board.

4. The current controlling transducer according to any preceding claim wherein the microprocessor further comprises a condition monitor (34) connected to an output of the one or more current sensors, the condition monitor comprising a condition data store (35) in the memory (50) of the microprocessor configured to store historical data concerning information from the current sensors.

5. The current controlling transducer according to any preceding claim wherein the communication interface is configured to be connected to the external higher level controller via a serial link (29).

6. The current controlling transducer according to any preceding claim, wherein an overmold layer (2) covers the magnetic field sensors and the microprocessor.

7. The current controlling transducer according to any preceding claim, wherein each primary conductor is comprised of circuit traces on the circuit board, comprising circuit trace pads (6a, 6b) interconnected by a narrow bridge section (5).

8. The current controlling transducer according to any preceding claim, wherein a connection layout of the circuit board is implemented in a Land Grid Array (LGA) package that comprises the circuit board, circuit traces on a first side (1a) of the circuit board including ground, power supply, and the communication interface connection terminals (3), and an overmold layer (2) on a second side (1b) of the circuit board covering the magnetic field sensors and the microprocessor.

9. The current controlling transducer according to any preceding claim 1-7, wherein each current sensor comprises a magnetic core (9) at least partially surrounding a mid-section (6c) of each primary conductors and wherein the circuit board comprises slots (14) configured to allow branches (9b) of the magnetic core to extend through the circuit board from a first side (1a) to the second side (1b).

10. The current controlling transducer according to any preceding claim 1-7, further comprising a compensation coil (13), wherein each current sensor comprises a magnetic core (9) surrounding the primary conductor and extending through a core of a compensation coil (13), an airgap being formed between a branch of the magnetic core that extends through the core of the compensation coil up to a first side (1a) of the circuit board and an end branch (9a) of the magnetic core extending over the second side (1b) of the circuit board, the magnetic field detector being mounted on a second side of the circuit board and positioned in the airgap.

11. The current controlling transducer according to the preceding claim, wherein the connection terminals of the connector extend along an edge (1c) of the circuit board.

12. The current controlling transducer according to either of the two directly preceding claims, wherein the primary conductor comprises a plurality of conductor sections (6') forming U-shaped conductors section mounted around the compensation coil.

## Patentansprüche

1. Stromregulierender Wandler, der eine Leiterplatte (1), einen oder mehrere Stromsensoren (22), mindestens einen Mikroprozessor (8) auf der Leiterplatte und einen Verbinder (3) mit Verbindungsanschlüssen umfasst, die mit der Leiterplatte verbunden sind und dazu ausgestaltet sind, über einen externen Verbinder oder eine zusätzliche Leiterplatte mit einem Leistungsumwandlungssystem (32) und einer Steuereinrichtung (30) einer höheren Ebene außerhalb des Wandlers verbunden zu sein,
wobei jeder Stromsensor einen Hauptleiter (6) mit Eingangs- und Ausgangsanschlüssen (6a, 6b), die dazu ausgestaltet sind, mit einer elektrischen Phase des Leistungsumwandlungssystem verbunden zu sein, und einen Magnetfelddetektor (7) umfasst, der dazu ausgestaltet ist, das Magnetfeld, das durch einen Hauptstrom, der in dem Hauptleiter fließt, erzeugt wird, zu messen, wobei jeder Stromsensor mit einer Steuereinrichtung (21) des Mikroprozessors verbunden ist,
wobei der Mikroprozessor ferner Folgendes umfasst:
eine Kommunikationsschnittstelle (28), die dazu ausgestaltet ist, mit der Steuereinrichtung der höheren Ebene über die Verbindungsanschlüsse des Verbinders zu kommunizieren, und
einen Speicher (50), der einen Konfigurationsdatenspeicher (33) umfasst, der dazu ausgestaltet ist, Informationen zu speichern, die eine Konfiguration des Leistungsumwandlungssystems betreffen,
wobei der Mikroprozessor mit einem oder mehreren Steuersignal-Verbindungsanschlüssen des Verbinders verbunden ist, die dazu ausgestaltet sind, mit dem Leistungsumwandlungssystem zu dessen Steuerung basierend auf Sollwert-Stromwerten und dem einen oder den mehreren von den Stromsensoren gemessenen Hauptströmen verbunden zu sein,
wobei die Sollwert-Stromwerte von der Steuereinrichtung (30) der höheren Ebene, dem Leistungsumwandlungssystem (32) oder dem Speicher (50) bereitgestellt werden oder von der Steuereinrichtung (21) basierend auf den Informationen, welche die Konfiguration des Leistungsumwandlungssystems betreffen, die in dem Konfigurationsdatenspeicher (33) gespeichert sind, berechnet und bereitgestellt werden, und
wobei der Hauptleiter, der Magnetfeldsensor, der Mikroprozessor, die Leiterplatte und der Verbinder direkt zusammen integriert sind, um eine einzige Einheit zu bilden, die mit dem Leistungsumwandlungssystem und einer Steuereinrichtung des Leistungsumwandlungssystems verbindbar ist.

2. Stromregulierender Wandler nach dem vorhergehenden Anspruch, wobei der Mikroprozessor (8) ferner eine Analog/Digitalschaltung (25) umfasst und wobei jeder Stromsensor mit der Analog/Digitalschaltung (25) des Mikroprozessors verbunden ist.

3. Stromregulierender Wandler nach einem der vorhergehenden Ansprüche, wobei die Verbindungsanschlüsse des Verbinders auf einer ersten Seite (1a) der Leiterplatte bereitgestellt sind und der Magnetfeldsensor und Mikroprozessor auf einer zweiten Seite (1b) der Leiterplatte montiert sind.

4. Stromregulierender Wandler nach einem der vorhergehenden Ansprüche, wobei der Mikroprozessor ferner eine Bedingungsüberwachungseinrichtung (34) umfasst, die mit einem Ausgang des einen oder der mehreren Stromsensoren verbunden ist, wobei die Bedingungsüberwachungseinrichtung einen Bedingungsdatenspeicher (35) in dem Speicher (50) des Mikroprozessors umfasst, der dazu ausgestaltet ist, Verlaufsdaten zu speichern, die Informationen von den Stromsensoren betreffen.

5. Stromregulierender Wandler nach einem der vorhergehenden Ansprüche, wobei die Kommunikationsschnittstelle dazu ausgestaltet ist, mit der externen Steuereinrichtung der höheren Ebene über eine serielle Verbindung (29) verbunden zu sein.

6. Stromregulierender Wandler nach einem der vorhergehenden Ansprüche, wobei eine übergossene Schicht (2) die Magnetfeldsensoren und den Mikroprozessor bedeckt.

7. Stromregulierender Wandler nach einem der vorhergehenden Ansprüche, wobei jeder Hauptleiter aus Leiterbahnen auf der Leiterplatte besteht, die Leiterbahn-Kontaktgebiete (6a, 6b) umfassen, die durch einen schmalen Brückenabschnitt (5) zusammengeschaltet sind.

8. Stromregulierender Wandler nach einem der vorhergehenden Ansprüche, wobei ein Verbindungslayout der Leiterplatte in einem Land Grid Array (LGA) Package implementiert ist, das die Leiterplatte, Leiterbahnen auf einer ersten Seite (1a) der Leiterplatte, die Masse, Leistungsversorgung und die Kommunikationsschnittstellen-Verbindungsanschlüsse (3) umfassen, und eine übergossene Schicht (2) auf einer zweiten Seite (1b) der Leiterplatte umfasst, welche die Magnetfeldsensoren und den Mikroprozessor bedeckt.

9. Stromregulierender Wandler nach einem der Ansprüche 1 bis 7, wobei jeder Stromsensor einen Magnetkern (9) umfasst, der einen mittleren Abschnitt (6c) von jedem Hauptleiter zumindest teilweise umgibt, und wobei die Leiterplatte Schlitze (14) umfasst, die dazu ausgestaltet sind, es Verzweigungen (9b) des Magnetkerns zu erlauben, sich von einer ersten Seite (1a) zur zweiten Seite (1b) durch die Leiterplatte zu erstrecken.

10. Stromregulierender Wandler nach einem der vorhergehenden Ansprüche 1 bis 7, der ferner eine Kompensationswicklung (13) umfasst, wobei jeder Stromsensor einen Magnetkern (9) umfasst, der den Hauptleiter umgibt und sich durch einen Kern der Kompensationswicklung (13) erstreckt, wobei ein Luftspalt zwischen einer Verzweigung des Magnetkerns, die sich durch den Kern der Kompensationswicklung hinauf bis zu einer ersten Seite (1a) der Leiterplatte erstreckt, und einer Endverzweigung (9a) des Magnetkerns gebildet ist, die sich über der zweiten Seite (1b) der Leiterplatte erstreckt, wobei der Magnetfelddetektor auf einer zweiten Seite der Leiterplatte montiert ist und in dem Luftspalt positioniert ist.

11. Stromregulierender Wandler nach dem vorhergehenden Anspruch, wobei die Verbindungsanschlüsse des Verbinders sich entlang eines Randes (1c) der Leiterplatte erstrecken.

12. Stromregulierender Wandler nach einem der beiden direkt vorhergehenden Ansprüche, wobei der Hauptleiter eine Vielzahl von Leiterabschnitten (6') umfasst, die U-förmige Leiterabschnitte bilden, die um die Kompensationswicklung montiert sind.

## Revendications

1. Transducteur de commande de courant comprenant une carte de circuit (1), un ou plusieurs capteurs de courant (22), au moins un microprocesseur (8) sur la carte de circuit et un connecteur (3) comportant des bornes de connexion connectées à la carte de circuit et configuré pour être connecté, via un connecteur externe ou une carte de circuit supplémentaire, à un système de conversion de puissance (32) et à un dispositif de commande de niveau supérieur (30) externe au transducteur,
dans lequel chaque capteur de courant comprend un conducteur primaire (6) comportant des bornes d'entrée et de sortie (6a, 6b), configuré pour être connecté à une phase électrique du système de conversion de puissance, et un détecteur de champ magnétique (7) configuré pour mesurer le champ magnétique généré par un courant primaire circulant dans le conducteur primaire, chaque capteur de courant étant connecté à un dispositif de commande (21) du microprocesseur,
le microprocesseur comprenant en outre
une interface de communication (28) configurée pour communiquer avec le dispositif de commande de niveau supérieur via les bornes de connexion du connecteur, et
une mémoire (50) comprenant un magasin de données de configuration (33) configuré pour stocker des informations concernant une configuration du système de conversion de puissance,
dans lequel le microprocesseur est connecté à une ou plusieurs bornes de connexion de signal de commande du connecteur configurées pour être connectées au système de conversion de puissance pour le commander sur la base de valeurs de courant de point de consigne et des un ou plusieurs courants primaires mesurés par les capteurs de courant,
dans lequel les valeurs de courant de point de consigne sont fournies par le dispositif de commande de niveau supérieur (30), le système de conversion de puissance (32) ou la mémoire (50), ou sont calculées et fournies par le dispositif de commande (21) sur la base des informations concernant la configuration du système de conversion de puissance stockées dans le magasin de données de configuration (33), et
dans lequel le conducteur primaire, le capteur de champ magnétique, le microprocesseur, la carte de circuit et le connecteur sont directement intégrés ensemble pour former une unité unique pouvant être connectée au système de conversion de puissance et à un dispositif de commande du système de conversion de puissance.

2. Transducteur de commande de courant selon la revendication précédente dans lequel le microprocesseur (8) comprend en outre un circuit analogique-numérique (25), et dans lequel chaque capteur de courant est connecté au circuit analogique-numérique (25) du microprocesseur.

3. Transducteur de commande de courant selon l'une quelconque des revendications précédentes dans lequel les bornes de connexion du connecteur sont prévues sur un premier côté (1a) de la carte de circuit, et le capteur de champ magnétique et le microprocesseur sont montés sur un deuxième côté (1b) de la carte de circuit.

4. Transducteur de commande de courant selon l'une quelconque des revendications précédentes dans lequel le microprocesseur comprend en outre un dispositif de surveillance de conditions (34) connecté à une sortie des un ou plusieurs capteurs de courant, le dispositif de surveillance de conditions comprenant un magasin de données de conditions (35) dans la mémoire (50) du microprocesseur configuré pour stocker des données historiques concernant des informations provenant des capteurs de courant.

5. Transducteur de commande de courant selon l'une quelconque des revendications précédentes dans lequel l'interface de communication est configurée pour être connectée au dispositif de commande de niveau supérieur externe via une liaison série (29).

6. Transducteur de commande de courant selon l'une quelconque des revendications précédentes, dans lequel une couche de surmoulage (2) recouvre les capteurs de champ magnétique et le microprocesseur.

7. Transducteur de commande de courant selon l'une quelconque des revendications précédentes, dans lequel chaque conducteur primaire est constitué de traces de circuit sur la carte de circuit, comprenant des plages de trace de circuit (6a, 6b) interconnectées par une section de pont étroite (5).

8. Transducteur de commande de courant selon l'une quelconque des revendications précédentes, dans lequel un schéma de connexion de la carte de circuit est mis en œuvre dans un paquet de boîtier à matrice de plots (LGA) qui comprend la carte de circuit , des traces de circuit sur un premier côté (1a) de la carte de circuit comportant une masse, une alimentation électrique et l'interface de communication bornes de connexion (3), et une couche de surmoulage (2) sur un deuxième côté (1b) de la carte de circuit recouvrant les capteurs de champ magnétique et le microprocesseur.

9. Transducteur de commande de courant selon l'une quelconque des revendications précédentes 1 à 7, dans lequel chaque capteur de courant comprend un noyau magnétique (9) entourant au moins partiellement une section médiane (6c) de chaque conducteur primaire, et dans lequel la carte de circuit comprend des fentes (14) configurées pour permettre à des branches (9b) du noyau magnétique de s'étendre à travers la carte de circuit d'un premier côté (1a) au deuxième côté (1b).

10. Transducteur de commande de courant selon l'une quelconque des revendications précédentes 1 à 7, comprenant en outre une bobine de compensation (13), dans lequel chaque capteur de courant comprend un noyau magnétique (9) entourant le conducteur primaire et s'étendant à travers un noyau d'une bobine de compensation (13), un entrefer étant formé entre une branche du noyau magnétique qui s'étend à travers le noyau de la bobine de compensation jusqu'à un premier côté (1a) de la carte de circuit , et une branche (9a) d'extrémité du noyau magnétique s'étendant sur le deuxième côté (1b) de la carte de circuit , le détecteur de champ magnétique étant monté sur un deuxième côté de la carte de circuit et positionné dans l'entrefer.

11. Transducteur de commande de courant selon la revendication précédente, dans lequel les bornes de connexion du connecteur s'étendent le long d'un bord (1c) de la carte de circuit.

12. Transducteur de commande de courant selon l'une des deux revendications directement précédentes, dans lequel le conducteur primaire comprend une pluralité de sections de conducteurs (6') formant une section de conducteurs en forme de U montée autour de la bobine de compensation.
